(19) Europäisches Patentamt
European Patent Office
Office européen des brevets

(11) **EP 4 439 883 A1**

(12) **EUROPEAN PATENT APPLICATION**

(43) Date of publication:
**02.10.2024 Bulletin 2024/40**

(21) Application number: **24159479.5**

(22) Date of filing: **23.02.2024**

(51) International Patent Classification (IPC):
*H01S 5/068* (2006.01)     *H01S 5/0683* (2006.01)

(52) Cooperative Patent Classification (CPC):
**H01S 5/0683; G01J 1/00; H01S 5/06808;**
H01S 5/0617

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **29.03.2023 IN 202311023127**

(71) Applicant: Honeywell International Inc.
**Charlotte, NC 28202 (US)**

(72) Inventors:
• **LENIN, Kaligaselvi**
  **Charlotte, 28202 (US)**

• **THINGALKODI, Ilanchezhian**
  **Charlotte, 28202 (US)**
• **TURK, Fethi**
  **Charlotte, 28202 (US)**
• **BROWN, Andy W.**
  **Charlotte, 28202 (US)**
• **SUBRAMANIAN, Hariprasath**
  **Charlotte, 28202 (US)**

(74) Representative: **Haseltine Lake Kempner LLP
Cheapside House
138 Cheapside
London EC2V 6BJ (GB)**

(54) **LASER CALIBRATION AND STABILIZATION ALGORITHM FOR MICROSCOPY DEVICE**

(57)     A method, system, and computer program product for determining calibration parameters for controlling the intensity of a laser diode are provided. An example method may include determining a slope representing a relation of a change in a photodiode output value to an input current transmitted to the laser diode. In the example method, the photodiode output value is received from a monitoring photodiode positioned to receive light from the laser diode, wherein the photodiode output value corresponds to the intensity of light generated by the laser diode and received at the monitoring photodiode. The example method further includes selecting an operating photodiode output value based at least in part on the slope, wherein the operating photodiode output value corresponds to a target photodiode current at the monitoring photodiode during operation.

FIG. 1

Description

TECHNOLOGICAL FIELD

Embodiments of the present disclosure relate generally to calibration and stabilization of a laser, and more specifically to calibration and stabilization of a laser operating in a microscopy device.

BACKGROUND

Applicant has identified many technical challenges and difficulties associated with causing a laser to generate a consistent, coherent electromagnetic beam. Through applied effort, ingenuity, and innovation, Applicant has solved problems related to calibrating and stabilizing the electromagnetic beam generated by a laser by developing solutions embodied in the present disclosure, which are described in detail below.

BRIEF SUMMARY

Various embodiments are directed to an example method, system, and computer program product for controlling the intensity of an illumination source, such that a consistent, coherent electromagnetic beam is generated.

An example method for calibrating an illumination source such that the intensity of light may be accurately controlled is provided. In some embodiments, the method may comprise determining a slope representing a relation of a change in a photodiode output value received from a monitoring photodiode to a change in an input current transmitted to the illumination source, wherein the photodiode output value corresponds to the intensity of the light received at the monitoring photodiode. In some embodiments, the method may further comprise selecting an operating photodiode output value based at least in part on the slope.

In some embodiments, the method may further comprise adjusting the input current transmitted to the illumination source to maintain a real-time photodiode output value at or near the operating photodiode output value.

In some embodiments, adjusting the input current provided to the illumination source may further comprise receiving a measured photodiode output value, comparing the measured photodiode output value to the operating photodiode output value, determining a difference between the measured photodiode output value and the operating photodiode output value, and in an instance in which the difference is greater than a max window size, adjusting the input current.

In some embodiments, determining the slope may comprise determining an input current difference representing a difference between a first input current and a second input current, determining a photodiode output difference representing a difference between a first photodiode output value and a second photodiode output value, wherein the first photodiode output value corresponds to the first input current and the second photodiode output value corresponds to the second input current, and determining a ratio between the input current difference and the photodiode output difference.

In some embodiments, selecting the operating photodiode output value may further comprise determining a plurality of slopes, each slope corresponding to a different range of input currents and corresponding range of photodiode output values and selecting the operating photodiode output value within the range of photodiode output values corresponding to the range of input currents and corresponding range of photodiode output values having a steepest slope.

In some embodiments, the illumination source may be a laser diode having an input current threshold corresponding to a minimum input current at which the laser diode will produce coherent light.

In some embodiments, the method may further comprise determining a linear approximation of a portion of a photodiode output current curve based at least in part on the slope and the operating photodiode output value, wherein the photodiode output current curve represents the relation of the input current to the photodiode output value; and determining the input current threshold based on an intersection point at which the photodiode output value of the linear approximation is zero.

In some embodiments, the operating photodiode output value may be selected by scaling the input current threshold by a pre-determined operating point scale factor.

In some embodiments, the operating point scale factor may be between 1.4 and 1.6.

In some embodiments, the input current threshold and the operating photodiode output value may be stored in a memory storage device.

In some embodiments, the input current may be controlled by a potentiometer.

An example system for calibrating an illumination source such that the intensity of light may be accurately controlled is further provided. In some embodiments, the example system may comprise an illumination source, a monitoring photodiode positioned to receive light from the illumination source, and a controller comprising a processor and an instruction memory including program code. In some embodiments, the instruction memory and program code may be configured to, with the processor, cause the message handler processor to determine a slope representing a relation of a change in a photodiode output value received from the monitoring photodiode to a change in an input current transmitted to the illumination source, wherein the photodiode output value corresponds to the intensity of light received at the monitoring photodiode and select an operating photodiode output value based at least in part on the slope.

In some embodiments, the controller may be further configured to adjust the input current transmitted to the illumination source to maintain a real-time photodiode output value at or near the operating photodiode output value.

In some embodiments, determining the slope may comprise determining an input current difference representing the difference between a first input current and a second input current; determining a photodiode output difference representing the difference between a first photodiode output value and a second photodiode output value, wherein the first photodiode output value corresponds to the first input current and the second photodiode output value corresponds to the second input current; and determining a ratio between the input current difference and the photodiode output difference.

In some embodiments, determining the operating photodiode output value may further comprise determining a plurality of slopes, each slope corresponding to a different range of input currents and corresponding range of photodiode output values; and selecting the operating photodiode output value within the range of photodiode output values corresponding to the range of input currents and corresponding range of photodiode output values having a steepest slope.

In some embodiments, the illumination source may be a laser diode having an input current threshold corresponding to a minimum input current at which the laser diode will produce coherent light.

In some embodiments, the controller may be further configured to determine a linear approximation of a portion of a photodiode output current curve based at least in part on the slope and the operating photodiode output value, wherein the photodiode output current curve represents the relation of the input current to the photodiode output value; and determine the input current threshold based on an intersection point at which the photodiode output value of the linear approximation is zero.

In some embodiments, the operating photodiode output value may be selected by scaling the input current threshold by a pre-determined operating point scale factor.

In some embodiments, the system may further comprise a potentiometer communicatively connected to the controller and electrically connected to the illumination source, wherein the controller controls the input current to the illumination source by transmitting an electrical signal to the potentiometer.

An example computer program product for calibrating an illumination source such that the intensity of light may be accurately controlled is further provided. In some embodiments, the computer program product may comprise at least one non-transitory computer-readable storage medium having computer-readable program code portions stored therein, the computer-readable program code portions comprising an executable portion configured to determine a slope representing a relation of a change in a photodiode output value received from a monitoring photodiode to a change in an input current transmitted to the illumination source wherein the photodiode output value corresponds to the intensity of a light received at the monitoring photodiode; and select an operating photodiode output value based at least in part on the slope.

## BRIEF DESCRIPTION OF THE DRAWINGS

Reference will now be made to the accompanying drawings. The components illustrated in the figures may or may not be present in certain embodiments described herein. Some embodiments may include fewer (or more) components than those shown in the figures in accordance with an example embodiment of the present disclosure.

FIG. 1 illustrates an example block diagram of an example laser driver circuit in accordance with an example embodiment of the present disclosure.

FIG. 2 illustrates an example block diagram showing example components of a controller in accordance with an example embodiment of the present disclosure.

FIG. 3 depicts an example flow diagram illustrating an example process for calibrating and stabilizing a laser output in accordance with an example embodiment of the present disclosure.

FIG. 4 depicts a flowchart illustrating an example method for determining calibration parameters of a laser driver circuit.

FIG. 5 depicts an example flow diagram illustrating a process for determining the calibration parameters of an illumination source based on the photodiode output value of a monitoring photodiode in accordance with an example embodiment of the present disclosure.

FIG. 6 depicts an example graph illustrating a process for calculating multiple slopes to determine the linear region of operation of a laser driver circuit in accordance with an example embodiment of the present disclosure.

FIG. 7 depicts a graph of an example photodiode output value of a monitoring photodiode corresponding to an input current provided to an illumination source in accordance with an example embodiment of the present disclosure.

FIG. 8A - FIG. 8D depict several example differences in the photodiode output value of a monitoring photodiode corresponding to an input current provided to an illumination source on various laser driver circuits in accordance with an example embodiment of the present disclosure.

FIG. 9 depicts a flowchart illustrating an example method for stabilizing a laser output from a laser driver circuit in accordance with an example embodiment of the present disclosure.

FIG. 10 depicts a flowchart illustrating an example process for stabilizing a laser output during operation in accordance with an example embodiment of the present disclosure.

## DETAILED DESCRIPTION

Example embodiments will be described more fully hereinafter with reference to the accompanying drawings, in which some, but not all embodiments of the inventions of the disclosure are shown. Indeed, embodiments of the disclosure may be embodied in many different forms and should not be construed as limited to the embodiments set forth herein; rather, these embodiments are provided so that this disclosure will satisfy applicable legal requirements. Like numbers refer to like elements throughout.

Various example embodiments address technical problems associated with utilizing a laser driver circuit to calibrate and stabilize the electromagnetic output of a laser (e.g., laser output). As understood by those of skill in the field to which the present disclosure pertains, there are numerous example scenarios in which the laser output may need to be calibrated and stabilized to produce a stable coherent output laser beam. One such example is a device utilizing digital holography, such as a blood cytometry device.

A blood cytometry device may be utilized to determine physical characteristics and counts of cells in a patients bodily fluid. Physical information pertaining to the cells in a patient's body may provide helpful insights into the overall health of the patient. For example, cytometry measurements can be used to count types of white blood cells, indicative of the health of a patient's immune system. Cytometry measurements may also be used to perform complete blood counts which may indicate diseases, disorders, or infections in a patient. In addition, cytometry measurements can be used to identify cancer cells or identify other anomalies in a patient's cells.

A blood cytometry device may comprise a narrow passage, or nozzle that forces the cells in a bodily fluid sample to pass in a single file line in front of an illumination source (e.g., laser). In some embodiments, the cells may be coated in fluorochromes, or a similar substance based on the type of cell. In such an instance, when the fluorochrome coated cell passes into the laser output, the cell emits a light that may be sensed by a nearby photodiode. In some embodiments, the illumination source may emit various wavelengths of light, and the physical characteristics and count of the cells may be determined based on the reflection and/or scatter of the illumination source.

In some embodiments, the blood cytometry device may utilize lens-less holographic microscopy to determine the physical characteristics and count of the cells. In such an embodiment, a laser output may be used to illuminate the cells or particles in the bodily fluid. The laser output interacting with the cells may be scattered in various directions and captured by an image sensor. The captured laser light may then be processed in order to reconstruct an image, or digital hologram, of the illuminated cells. The resulting digital hologram enables a high-resolution of image of the cells to be determined and analyzed without the aid of fluorochromes or other similar substances. From the digital hologram, highly accurate physical characteristics of the cells and cell counts may be determined.

In order to generate accurate measurements of cells in a blood cytometry device, a consistent, coherent laser output may be used. For example, accurate recreations of the illuminated cells based on the reflection of the laser off of cells is highly dependent on the output intensity of the laser. If the output intensity of the laser increases and/or decreases over time, the measurements generated by a receiving imaging device may be affected.

In addition to producing a stable output, a laser must receive a minimum input current (or threshold current) before the laser produces coherent output light with a single wavelength, which is essential to creating an accurate digital hologram and to the correct operation of the blood cytometry device.

In some examples, a laser can change characteristics as the temperature of the laser changes. For example, as the laser heats up over continued use, the output power and the wavelength of the laser output may vary. Changes in the physical properties of the laser output may affect the image quality of the generated digital hologram. In addition, in some embodiments, the laser may include a photodiode monitor. The photodiode monitor may be utilized to provide feedback on the power of the laser output of the illumination source. However, various photodiode monitors may be inconsistent between laser driver circuits.

In general, laser diode driver circuits utilize one of two modes to control the laser output generated by the laser driver circuit: constant current mode or constant power mode. Constant current mode seeks to control the laser output generated by the laser driver circuit by monitoring and adjusting the input current provided to the laser diode. In theory, utilizing the input current to the laser diode as a feedback control and providing a constant input current should lead to a stable, coherent laser output. However, the properties of the generated laser output may change during operation. For example, the temperature of the laser driver circuit may increase during operation, changing the generated laser output. In some examples active heat regulation techniques may be used to actively control the temperature of the laser and generate a consistent, coherent laser output. However, in some embodiments, the active heat regulation techniques may be bulky, complex, and expensive. The cost, complexity, and size of the active heat regulation components may eliminate the use of this technique from blood cytometry devices and other microscopy devices used in individual medical contexts where simple, cheap (e.g., disposable), and accurate measuring devices are preferred.

Constant power mode seeks to control the generated laser output by monitoring and stabilizing the photodiode current (e.g., photodiode output value) of a monitoring photodiode. In theory, utilizing the photodiode current of the monitoring photodiode as a feedback control should stabilize the generated laser output. However, the properties of photodiodes may vary significantly, resulting in inconsistent laser output between laser driver circuits, even if the photodiode current of the monitoring photodiode is constant.

The various example embodiments described here utilize various techniques to determine a configuration of a laser driver circuit and generate a stable, coherent laser output. For example, in some embodiments, a laser driver circuit may determine the configuration parameters of a particular laser and monitoring photodiode on the laser driver circuit. In one embodiment, a laser driver circuit may adjust the input current to an illumination source (e.g., laser) to control the intensity of light generated by the illumination source. The laser driver circuit may further receive measurements from a monitoring photodiode (e.g., photodiode output value), indicating the intensity of light generated by the illumination source. The laser driver circuit may adjust the input current and record the intensity of light or correlated photodiode output value in relation to the input current. The laser driver circuit may then determine the linear region of operation based on the relation of the photodiode output value to the input current. Utilizing the slope of the photodiode output value, the laser driver circuit may determine a number of calibration parameters, including but not limited to the threshold point at which the illumination source begins to operate coherently, an operating photodiode output value, and a unit step size for operating the illumination source. The laser driver circuit may store these determinations for use during operation. Determining such calibration parameters may overcome a number of challenges associated with differences in various monitoring photodiodes.

In addition, the laser driver circuit may utilize the calibration parameters determined during calibration to control the intensity of the illumination source during operation. In some embodiments, the laser driver circuit may receive and monitor the photodiode current (e.g., photodiode output value) to ensure a coherent and stable laser output. For example, the laser driver circuit may read the photodiode current periodically during the operation of the laser. The laser driver circuit may compare the real-time photodiode output value to the determined operating photodiode output value and adjust the input current to the laser diode in an instance in which the real-time photodiode output value falls outside of a unit step size indicating the range of photodiode output values determined for a coherent and stable generated laser output. In some embodiments, the laser driver circuit may update calibration parameters, for example in an instance in which the image pixels are too bright, or too dim, even when the real-time photodiode output value is measured within the unit step size.

As a result of the herein described example embodiments and in some examples, the effectiveness of a laser driver circuit in ensuring a coherent and stable intensity of light from an illumination source (e.g., laser) may be greatly improved. In addition, such a laser driver circuit may greatly reduce the overall cost of a coherent and stable laser source, enabling use of such a laser driver circuit in individual medical contexts where simple, cheap (e.g., disposable), and accurate measuring devices are preferred, such as a blood cytometry device.

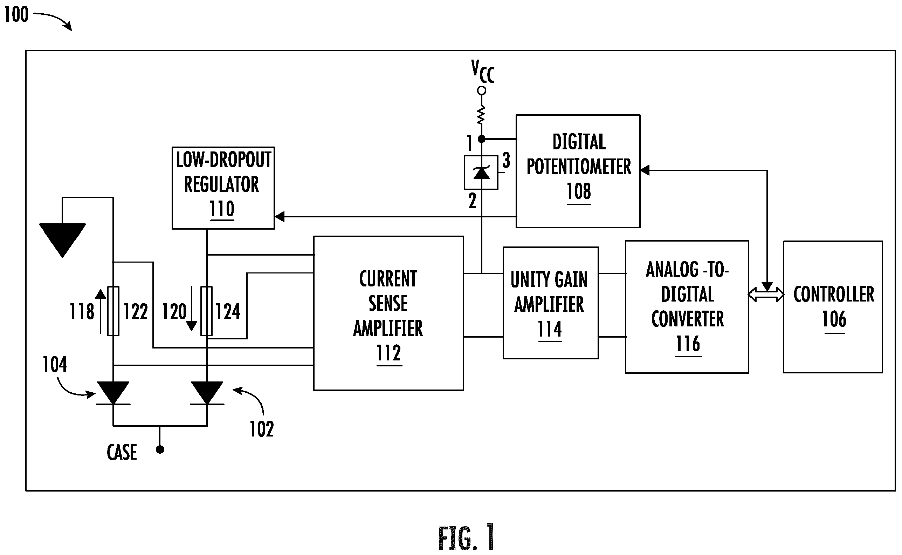

Referring now to FIG. 1, an example laser driver circuit 100 is provided. As depicted in FIG. 1, the example laser driver circuit 100 includes a laser diode 102 and a photodiode 104 positioned to monitor the generated laser output of the laser diode 102. The example laser driver circuit 100 further includes a current sense amplifier 112 electrically connected to the output of the photodiode 104 and configured to measure the photodiode current 118 (e.g., photodiode output value) of the photodiode 104. The current sense amplifier 112, as depicted, is also electrically connected to the laser diode 102 input providing input power to the laser diode 102, wherein the current sense amplifier 112 is configured to measure the laser diode input current 120 (e.g., input current) transmitted to the laser diode 102. The current sense amplifier 112 is additionally electrically connected to a unity gain amplifier 114, which is in turn electrically connected to an analog-to-digital converter 116 each configured to condition the values measured by the current sense amplifier 112 for to be received by the controller 106.

As depicted in FIG. 1, the controller 106 is electrically connected to the analog-to-digital converter 116 and receives a conditioned representation of the laser diode input current 120 and the photodiode current 118 from the analog-to-digital converter 116. In addition, the controller 106 is electrically and/or communicatively connected to a digital potentiometer 108. The digital potentiometer 108 is further electrically connected to a low-dropout regulator 110 which is in turn electrically connect to the laser diode 102. The digital potentiometer 108 may be configured to adjust the laser diode input current 120 provided to the laser diode 102.

As depicted in FIG. 1, the example laser driver circuit 100 includes a laser diode 102. A laser diode 102 may be any semiconductor device configured utilize electric energy to emit a coherent light source or laser output. In some embodiments, the laser diode may comprise a gain cavity or active region between two semiconductor materials that have been doped with impurities to create a p-n junction. When voltage is applied to the p-n junction, electrons and holes are forced into the active region in an excited state. The laser diode 102 may further comprise reflectors that contain the excited photons in the active region. The excited photons may build up within the active until they reach a threshold at which lasing occurs, resulting in the emission of the photons in a coherent wavelength beam of light, or laser output, consisting of photons of the same energy and phase. In some embodiments, the photon emission may be the result of stimulated emission. In some embodiments, a laser diode 102 may be configured as an edge-emitting laser. In some embodiments, a laser diode may be configured as a surface-emitting diode.

An individual laser diode 102 may further comprise an input current threshold. An input current threshold is the minimum input current (e.g., laser diode input current 120) provided to a laser diode 102 above which, photons are emitted as coherent light. Coherent light may be any light output from an illumination source consisting of photons having the same frequency, wavelength, and phase. The coherence of laser light is the result of the process of stimulated emission. The high coherence of laser light allows a generated laser output to focused to a small sport and/or transmitted with minimal dispersion. A laser diode 102 operating below the input current threshold outputs incoherent light that may be dispersed in many directions. A coherent light illumination source enables highly accurate digital holograms to be produced. Highly accurate digital holograms may be an important part of medical devices, such as a blood cytometry device.

As further depicted in FIG. 1, the example laser driver circuit includes a photodiode 104 (e.g., monitoring photodiode). A photodiode 104 may be any device, sensor, semiconductor device, or other structure that produces an electric current (e.g., photodiode current 118) proportional to the intensity of light received at the photodiode 104. In some embodiments, the photodiode 104 may be a light sensitive semiconductor diode that creates an electron-hole pair at the p-n junction when a photon of sufficient energy strikes the diode. In some embodiments, the electric current output by the photodiode 104 may increase as the number of photons that strike the photodiode 104 per second increases. In such an embodiment, the electric current output from the one or more photodiodes 104 may be used to determine the intensity of light striking the photodiode 104.

As further depicted in FIG. 1, the photodiode 104 is positioned to monitor the output of an illumination source (e.g., the laser output from laser diode 102). In some embodiments, a portion of the output of the illumination source may be received by the photodiode 104 (e.g., monitoring photodiode). The photodiode may produce an output current (e.g., photodiode current 118) corresponding to the generated output of the illumination source. Utilizing the photodiode current 118 to monitor the intensity of the light source may enable the laser driver circuit 100 to control the output power of the illumination source, for example, as in constant power mode.

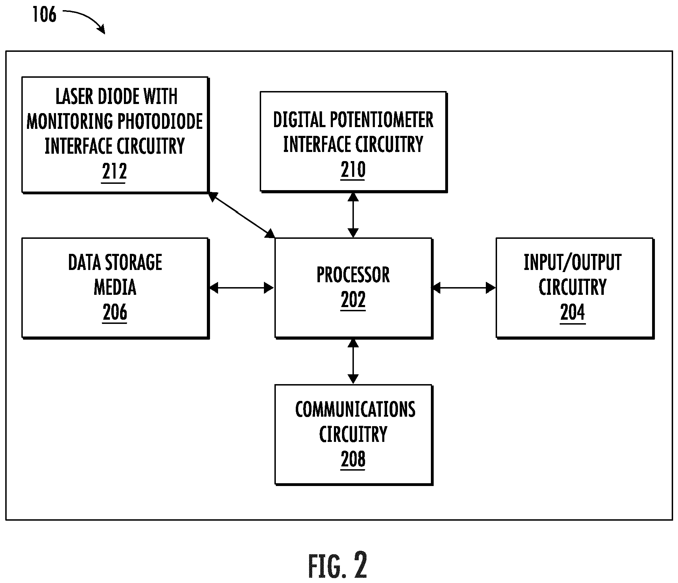

As further depicted in FIG. 1, the example laser driver circuit 100 includes a controller 106. A controller 106 may be any means such as a processor, device, or circuitry embodied in either hardware or a combination of hardware and software that is configured at least to receive measurements corresponding to the photodiode current 118 and the laser diode input current 120 and determine the configuration of the digital potentiometer 108 based at least in part on the received values. The controller 106 may comprise a configuration as shown and described in relation to FIG. 2. While FIG. 2 provides an example block diagram of a controller 106, it is noted that the scope of the present disclosure is not limited to the example shown in FIG. 2.

As further depicted in FIG. 1, the photodiode current 118 and/or the laser diode input current 120 pass through a series of electronic devices (e.g., current sense amplifier 112, unity gain amplifier 114, analog-to-digital converter 116), conditioning the respective signals to be received at the controller 106.

The current sense amplifier 112 may be any device or circuitry embodied in either hardware or a combination of hardware and software that is configured at least to produce an output voltage, greater in amplitude but proportional to, a received input voltage. As depicted in FIG. 1, the current sense amplifier 112 may utilize the voltage drop across a shunt resistor (e.g., shunt resistor 122, 124) to determine the current in a conducting device. The current sense amplifier of FIG. 1 may be utilized to amplify the measured photodiode current 118 and the laser diode input current 120.

The unity gain amplifier 114 may be any device or circuitry embodied in either hardware or a combination of hardware and software that is configured at least to buffer a received signal, for example, by providing a high input impedance and a low output impedance without changing the voltage level of the signal. In some embodiments, the unity gain amplifier 114 may prevent signal distortion and improve signal-to-noise ratio (SNR). The unity gain amplifier 114 of FIG. 1 may be utilized to condition the measured photodiode current 118 and the laser diode input current 120.

The analog-to-digital converter 116 may be any device or circuitry embodied in either hardware or a combination of hardware and software that is configured at least to convert a continuous analog signal, such as a voltage or current, into a discrete digital representation. The analog-to-digital converter 116 of FIG. 1 may be utilized to convert the measured photodiode current 118 and the laser diode input current 120 into digital signals to be received and analyzed by the controller 106.

As further depicted in FIG. 1, the example laser driver circuit 100 includes a digital potentiometer 108. A digital potentiometer 108 may be any device or circuitry embodied in either hardware or a combination of hardware and software that is configured at least to receive an electronic signal through an external control interface and adjust the resistance of the digital potentiometer 108 based on the received electronic signal. As depicted in FIG. 1, the digital potentiometer 108 is used to control the voltage and/or current provided to the laser diode 102 and the subsequent intensity of the laser output. The controller 106 may transmit electronic signals to the digital potentiometer 108 to adjust the resistance of the digital potentiometer 108, setting the output voltage and/or current of the digital potentiometer 108, and thus controlling the laser diode input current 120 provided to the laser diode 102.

As further depicted in FIG. 1, the example laser driver circuit 100 includes a low-dropout regulator 110 configured to receive the output voltage of the digital potentiometer 108 and transmit a corresponding voltage to the laser diode 102. A low-dropout regulator 110 may be any device or circuitry embodied in either hardware or a combination of hardware and software that is configured at least to generate a stable output voltage corresponding to a received input voltage, even in an instance in which the generated output voltage is only slightly higher than the received input voltage. The low-dropout regulator 110 may enable the laser diode 102 to receive a stable and low-noise voltage source having at a laser diode input current 120.

Referring now to FIG. 2, FIG. 2 illustrates an example controller 106 in accordance with at least some example embodiments of the present disclosure. The controller 106 includes processor 202, input/output circuitry 204, data storage media 206, communications circuitry 208, digital potentiometer interface circuitry 210, and laser diode with monitoring photodiode interface circuitry 212. In some embodiments, the controller 106 is configured, using one or more of the sets of circuitry 202, 204, 206, 208, 210, and/or 212, to execute and perform the operations described herein.

Although components are described with respect to functional limitations, it should be understood that the particular implementations necessarily include the use of particular computing hardware. It should also be understood that in some embodiments certain of the components described herein include similar or common hardware. For example, two sets of circuitry may both leverage use of the same processor(s), network interface(s), storage medium(s), and/or the like, to perform their associated functions, such that duplicate hardware is not required for each set of circuitry. The user of the term "circuitry" as used herein with respect to components of the apparatuses described herein should therefore be understood to include particular hardware configured to perform the functions associated with the particular circuitry as described herein.

Particularly, the term "circuitry" should be understood broadly to include hardware and, in some embodiments, software for configuring the hardware. For example, in some embodiments, "circuitry" includes processing circuitry, storage media, network interfaces, input/output devices, and/or the like. Alternatively, or additionally, in some embodiments, other elements of the controller 106 provide or supplement the functionality of other particular sets of circuitry. For example, the processor 202 in some embodiments provides processing functionality to any of the sets of circuitry, the data storage media 206 provides storage functionality to any of the sets of circuitry, the communications circuitry 208 provides network interface functionality to any of the sets of circuitry, and/or the like.

In some embodiments, the processor 202 (and/or co-processor or any other processing circuitry assisting or otherwise associated with the processor) is/are in communication with the data storage media 206 via a bus for passing information among components of the controller 106. In some embodiments, for example, the data storage media 206 is non-transitory and may include, for example, one or more volatile and/or non-volatile memories. In other words, for example, the data storage media 206 in some embodiments includes or embodies an electronic storage device (e.g., a computer readable storage medium). In some embodiments, the data storage media 206 is configured to store information, data, content, applications, instructions, or the like, for enabling the controller 106 to carry out various functions in accordance with example embodiments of the present disclosure.

The processor 202 may be embodied in a number of different ways. For example, in some example embodiments, the processor 202 includes one or more processing devices configured to perform independently. Additionally, or alternatively, in some embodiments, the processor 202 includes one or more processor(s) configured in tandem via a bus to enable independent execution of instructions, pipelining, and/or multithreading. The use of the terms "processor" and "processing circuitry" should be understood to include a single core processor, a multi-core processor, multiple processors internal to the controller 106, and/or one or more remote or "cloud" processor(s) external to the controller 106.

In an example embodiment, the processor 202 is configured to execute instructions stored in the data storage media 206 or otherwise accessible to the processor. Alternatively, or additionally, the processor 202 in some embodiments is configured to execute hard-coded functionality. As such, whether configured by hardware or software methods, or by a combination thereof, the processor 202 represents an entity (e.g., physically embodied in circuitry) capable of performing operations according to an embodiment of the present disclosure while configured accordingly. Alternatively, or additionally, as another example in some example embodiments, when the processor 202 is embodied as an executor of software instructions, the instructions specifically configure the processor 202 to perform the algorithms embodied in the specific operations described herein when such instructions are executed.

As one particular example embodiment, the processor 202 is configured to perform various operations associated with calibrating the intensity of an illumination source (e.g., laser diode 102). In some embodiments, the processor 202 includes hardware, software, firmware, and/or a combination thereof, that determines a slope representing a relation of a change in a photodiode output value (e.g., photodiode current 118) received from a monitoring photodiode (e.g.,

photodiode 104) to a change in an input current (e.g., laser diode input current 120) transmitted to the illumination source, wherein the photodiode output value corresponds to the intensity of light received at the monitoring photodiode. Additionally, or alternatively, in some embodiments, the processor 202 includes hardware, software, firmware, and/or a combination thereof, that selects an operating photodiode output value based at least in part on the slope.

In another example embodiment, the processor 202 is configured to perform various operations associated with controlling the intensity of an illumination source (e.g., laser diode 102). In some embodiments, the processor 202 includes hardware, software, firmware, and/or a combination thereof, that receives a measured photodiode output value (e.g., photodiode current 118). Additionally, or alternatively, in some embodiments, the processor 202 includes hardware, software, firmware, and/or a combination thereof, that compares the measured photodiode output value to the operating photodiode output value. Additionally, or alternatively, in some embodiments, the processor 202 includes hardware, software, firmware, and/or a combination thereof, that determine a difference between the measured photodiode output value and the operating point photodiode output value. Additionally, or alternatively, in some embodiments, in an instance in which the difference is greater than a unit step size, the processor 202 includes hardware, software, firmware, and/or a combination thereof, that adjusts the input current.

In some embodiments, the controller 106 includes input/output circuitry 204 that provides output to the user and, in some embodiments, to receive an indication of a user input. In some embodiments, the input/output circuitry 204 is in communication with the processor 202 to provide such functionality. The input/output circuitry 204 may comprise one or more user interface(s) (e.g., user interface) and in some embodiments includes a display that comprises the interface(s) rendered as a web user interface, an application user interface, a user device, a backend system, or the like. The processor 202 and/or input/output circuitry 204 comprising the processor may be configured to control one or more functions of one or more user interface elements through computer program instructions (e.g., software and/or firmware) stored on a memory accessible to the processor (e.g., data storage media 206, and/or the like). In some embodiments, the input/output circuitry 204 includes or utilizes a user-facing application to provide input/output functionality to a client device and/or other display associated with a user.

In some embodiments, the controller 106 includes communications circuitry 208. The communications circuitry 208 includes any means such as a device or circuitry embodied in either hardware or a combination of hardware and software that is configured to receive and/or transmit data from/to a network and/or any other device, circuitry, or module in communication with the controller 106. In this regard, the communications circuitry 208 includes, for example in some embodiments, a network interface for enabling communications with a wired or wireless communications network. Additionally, or alternatively in some embodiments, the communications circuitry 208 includes one or more network interface card(s), antenna(s), bus(es), switch(es), router(s), modem(s), and supporting hardware, firmware, and/or software, or any other device suitable for enabling communications via one or more communications network(s). Additionally, or alternatively, the communications circuitry 208 includes circuitry for interacting with the antenna(s) and/or other hardware or software to cause transmission of signals via the antenna(s) or to handle receipt of signals received via the antenna(s). In some embodiments, the communications circuitry 208 enables transmission to and/or receipt of data from a client device in communication with the controller 106.

The digital potentiometer interface circuitry 210 includes hardware, software, firmware, and/or a combination thereof, that supports various functionality associated with configuring and/or communicating with a digital potentiometer (e.g., digital potentiometer 108). For example, in some embodiments, the digital potentiometer interface circuitry 210 includes hardware, software, firmware, and/or a combination thereof to interface with the external programming interface of the digital potentiometer. For example, the digital potentiometer interface circuitry 210 may transmit and receive signals according to an established protocol to provide appropriate configuration and/or calibration parameters in order to generate signals to configure the digital potentiometer to a resistance according to the desired laser diode input current for the laser diode (e.g., laser diode 102). In some embodiments, the digital potentiometer interface circuitry 210 includes a separate processor, specially configured field programmable gate array (FPGA), or a specially programmed application specific integrated circuit (ASIC).

The laser diode with monitoring photodiode interface circuitry 212 includes hardware, software, firmware, and/or a combination thereof, that supports various functionality associated with configuring an analog-to-digital converter (e.g., analog-to-digital converter 116). For example, in some embodiments, the laser diode with monitoring photodiode interface circuitry 212 includes hardware, software, firmware, and/or a combination thereof to receive digital signals corresponding to a photodiode current output value (e.g., photodiode current 118) and an input current (e.g., laser diode input current 120). The controller 106 may utilize such values to make a determination regarding the input value to the laser diode. In some embodiments, the laser diode with monitoring photodiode interface circuitry 212 includes a separate processor, specially configured field programmable gate array (FPGA), or a specially programmed application specific integrated circuit (ASIC).

Additionally, or alternatively, in some embodiments, one or more of the sets of circuitry 202-212 are combinable. Additionally, or alternatively, in some embodiments, one or more of the sets of circuitry perform some or all of the functionality described associated with another component. For example, in some embodiments, one or more sets of circuitry 202-212 are combined into a single module embodied in hardware, software, firmware, and/or a combination thereof. Similarly, in some embodiments, one or more of the sets of circuitry, for example digital potentiometer interface circuitry 210, and/or laser diode with monitoring photodiode interface circuitry 212, is/are combined such that the processor 202 performs one or more of the operations described above with respect to each of these circuitry individually.

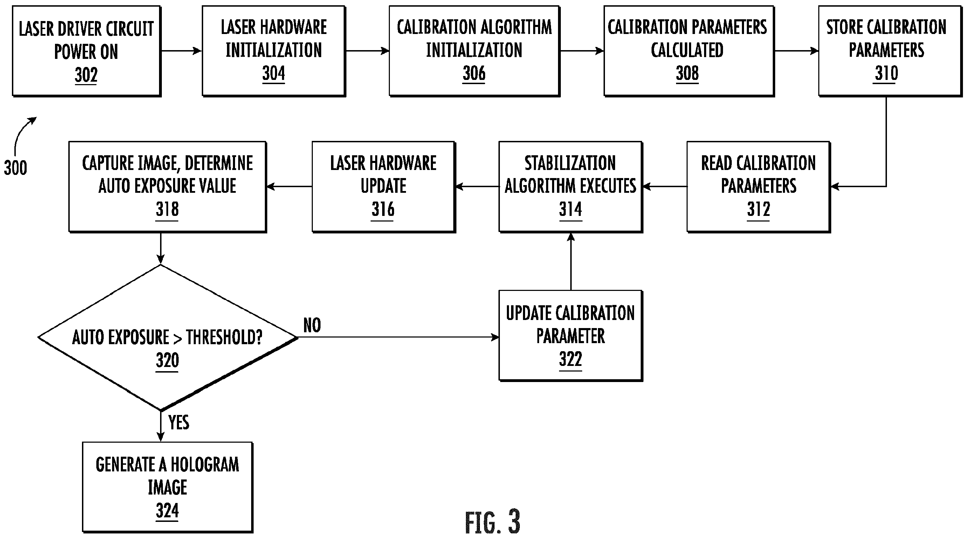

Referring now to FIG. 3, FIG. 3 illustrates an example process 300 for calibrating and controlling the intensity of an illumination source. At step 302, the laser driver circuit (e.g., laser driver circuit 100) is powered on.

At step 304, the laser hardware is initialized. Initialization of the laser hardware may include initial configuration and start-up of the electronic components, such as the controller 106, the digital potentiometer 108, low-dropout regulator 110, current sense amplifier 112, unity gain amplifier 114, and/or the analog-to-digital converter 116. Laser hardware initialization may further include monitoring power-up of laser hardware to ensure steady operation before the start of the calibration algorithm.

At step 306, the calibration algorithm is initialized. Initialization of the calibration algorithm may include assigning initial algorithm parameters, reading configuration values of associated hardware, setting parameters and default parameters based on the connected hardware, reading one or more configuration data files, and other actions to initialize the calibration algorithm for operation.

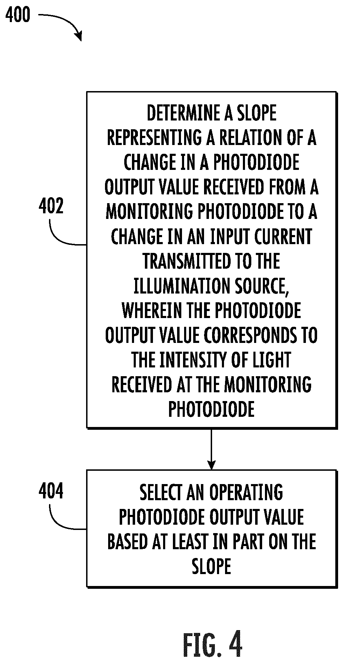

At step 308, the calibration parameters are calculated. The calibration parameters are calculated using a calibration algorithm. In general, the calibration algorithm determines at least the slope of the linear region of the photodiode output values as correlated with a change in the input current (e.g., laser diode input current 120). Further, based on the slope of the photodiode output value, the laser driver circuit may determine the threshold point at which the illumination source begins to operate coherently, an operating photodiode output value, and a unit step size for operating the illumination source. One or more embodiments of a calibration algorithm are described in relation to FIG. 4 - FIG. 8D.

At step 310, the calculated calibration parameters are store in a memory (e.g., data storage media 206) for use during the execution of the stabilization algorithm.

At step 312, the process for continuously monitoring and controlling the intensity of the illumination source begins by reading the stored calibration parameters. The stored calibration parameters provide insight into the initial operating photodiode output value and an associated range of photodiode output values (e.g., unit step size) within which the illumination source may effectively operate.

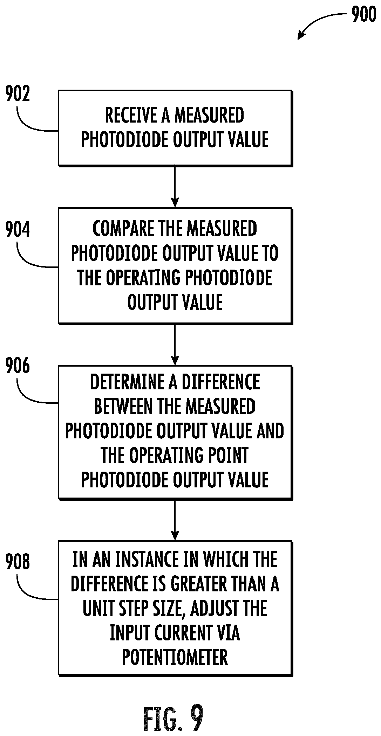

At step 314, the stabilization algorithm executes. The stabilization algorithm may be scheduled to execute periodically. In general, the stabilization algorithm may receive a measured photodiode output value, compare the measured photodiode output value to the operating photodiode output, and determine an updated input current based on the comparison. One or more embodiments of a stabilization algorithm are described in relation to FIG. 9 - FIG. 10.

At step 316, the laser hardware is updated based on the results of the stabilization algorithm. For example, the resistance of the digital potentiometer may be increased or decreased based on the determination of an updated input current.

At step 318, an image of the target holographic microscopy is captured by an imaging device. In practice, the digital hologram of the target object (e.g., cells in blood cytometry device) may be generated based on the image captured by the imaging device. In some embodiments, an auto exposure feature may be utilized by an imaging device or associated hardware to automatically adjust exposure settings such that the overall brightness of the image enables the features of the target object to be determined. Some imaging devices may automatically adjust camera parameters such as the aperture, exposure, shutter speed, ISO settings, and similar settings to produce an image with a brightness level enabling features of the captured image to be detected. In some instances, the auto exposure process may be applied in software in which the image pixels are artificially brightened or dimmed. In an instance in which the target object becomes too bright, for example due to the intensity of the illumination source, the imaging device may automatically adjust certain camera parameters such that the target object is not too bright. Some settings that may be automatically adjusted may reduce the quality of the image and the features of the target object. For example, if the exposure time is reduced to compensate for a captured image that is too bright, the quality of the image may be degraded, such that the features of the target object may not be detected.

In some embodiments, an auto exposure process may not be utilized. In such an instance, at step 318, the intensity of the image pixels on the captured image may be utilized to determine an auto exposure value. In some embodiments, an average pixel value may be determined for the entire captured image, or for a portion of the captured image. Utilizing the auto exposure value and/or image pixel intensity as feedback may enable the controller to further adjust the input current and subsequent intensity of the illumination source.

At step 320, the determined auto exposure value may be compared to an auto exposure threshold. An auto exposure threshold may be any parameter, variable, setting, or other numeric value specifying a minimum and/or maximum auto exposure value that may produce captured images at high enough quality to identify all necessary features of the target object. In an instance in which the auto exposure value is above a maximum auto exposure threshold or below a minimum auto exposure threshold, the process 300 may continue at step 322. However, in an instance in which the auto exposure value falls in an acceptable range, the process 300 may continue at step 324.

At step 322, the calibration parameters are updated based on the analysis of the auto exposure value of the captured image. In some embodiments, in an instance in which the auto exposure value of the captured image exceeds the maximum auto exposure threshold, the intensity of the illumination source may be too low and the camera parameters may have been adjusted to allow more light. The captured images may become blurred and the features of the target object indistinguishable. In such an instance, the operating photodiode output value and/or unit step size may be adjusted such that the intensity of the illumination source may be increased. In some embodiments, in an instance in which the auto exposure value of the captured image is below the minimum auto exposure threshold, the intensity of the illumination source is too high and the camera parameters have been adjusted to collect less light from the target object. The captured images may become grainy or unfocused and the features of the target object may be indistinguishable. In such an instance, the operating photodiode output value and/or unit step size may be adjusted such that the intensity of the illumination source may be decreased. The updated calibration parameters may be stored and the process 300 may return to execution of the stabilization algorithm at step 314.

At step 324, the holographic microscopy device (e.g., blood cytometry device) may generate a hologram image based on the captured image by the imaging device. In an instance in which the controller determines the auto exposure value is within standard operating parameters, the holographic microscopy device may utilize the captured image or images to generate a hologram image, accurately representing the target object.

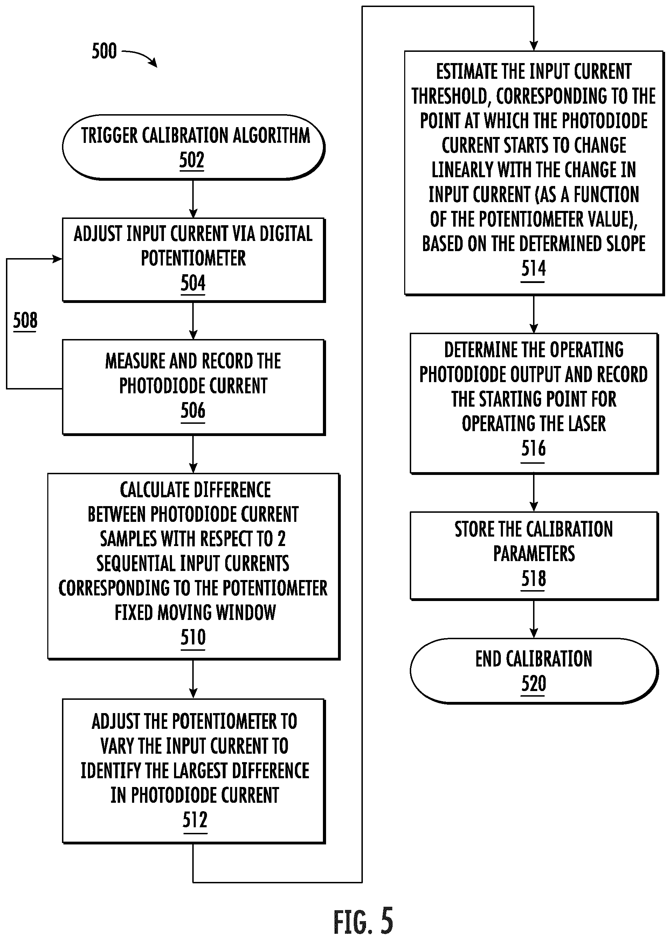

Referring now to FIG. 4, a process 400 for determining the calibration parameters to control an intensity of an illumination source (e.g., laser diode 102) is provided. At step 402, a controller (e.g., controller 106) determines a slope representing a relation of a change in a photodiode output value (e.g., photodiode current 118) received from a monitoring photodiode (e.g., photodiode 104) to a change in an input current (e.g., laser diode input current 120) transmitted to the illumination source (e.g., laser diode 102), wherein the photodiode output value corresponds to the intensity of light received at the monitoring photodiode. As described herein, the controller may receive a photodiode output value from a monitoring photodiode positioned to receive at least a portion of the light produced by an illumination source. In some embodiments, the photodiode output value corresponds to a current proportional to the intensity of light received at the monitoring photodiode. In addition, the controller may receive an input current corresponding to the input current provided to the illumination source. By varying the input current, for example by adjusting a digital variable resistor (e.g., digital potentiometer 108), and monitoring the corresponding photodiode output value, the controller may determine a slope representing the relation of the change in input current to the change in the photodiode output value across a range of input currents provided via a digital potentiometer. One or more embodiments depicting an example process for determining the slope representing the relation of a change in an input current to a change in a photodiode output value are described in relation to FIG. 5 - FIG. 8D.

At step 404, a controller may select an operating photodiode output value based at least in part on the slope. An operating photodiode output value may be any photodiode output (e.g., photodiode current 118) which the controller determines is an optimal photodiode output value to generate coherent light, produce quality images for digital hologram generation, and preserve power. In some embodiments, the operating photodiode output value is the target current a monitoring photodiode produces when exposed to the illumination source. In some embodiments, the operating photodiode output value may be based on the largest slope observed during the calibration process. The operating photodiode output value may be saved as a calibration parameter as a target for the stabilization algorithm. As further discussed in relation to FIG. 5 - FIG. 8D, the photodiode output value may be selected such that the photodiode output is greater than the input current threshold. In some embodiments, selecting a photodiode output value close to the input current threshold may preserve power and prevent the illumination source from saturating the target object with light. Example embodiments for determining the calibration parameters in a laser driver circuit are further provided in FIG. 5 - FIG. 8D.

Referring now to FIG. 5, an example process 500 for determining the calibration parameters to control an intensity of an illumination source (e.g., laser diode 102) of a laser driver circuit (e.g., laser driver circuit 100) are provided. At step 502, the calibration algorithm is triggered. In some instances, the calibration algorithm may be triggered any time the laser driver circuit is powered on. In some instances, the calibration algorithm may be scheduled to run periodically. For example, the calibration algorithm may be configured to run every ten seconds. In some instances, the calibration algorithm may be triggered in an instance in which the auto exposure value of the image capture device is too high or too low, as described in relation to FIG. 3.

At step 504, the controller adjusts the input current provided to the laser diode via a digital potentiometer (e.g., digital potentiometer 108) to a generate a first input current. In some embodiments, a digital potentiometer may comprise a plurality of discrete resistance settings at a fixed step size, for example, 100 ohms, 200 ohms, 300 ohms, etc. In some embodiments, the digital potentiometer may comprise a plurality of discrete resistance settings corresponding to a percentage of the max total resistance, for example, 10%, 20%, 30%, etc. The controller may be configured to adjust the setting of the digital potentiometer through an external interface.

At step 506, the controller may measure and record a first photodiode current (e.g., photodiode output value) corresponding to the first input current set in step 504 via the digital potentiometer.

At step 508, the controller may repeat step 504 and step 506, measuring and recording a second input current provided to the laser diode corresponding to a second photodiode current generated by the monitoring photodiode.

At step 510, the controller may calculate the difference between the first photodiode current and the second photodiode current to determine a photodiode current difference. In order to determine the slope representing the relation of the change in photodiode output value to the change in input current set by the digital potentiometer, in some embodiments, the controller may determine the change in the photodiode output current divided by the change in input current. In some embodiments, the change in input current may be a fixed amount, dictated by the digital potentiometer window size.

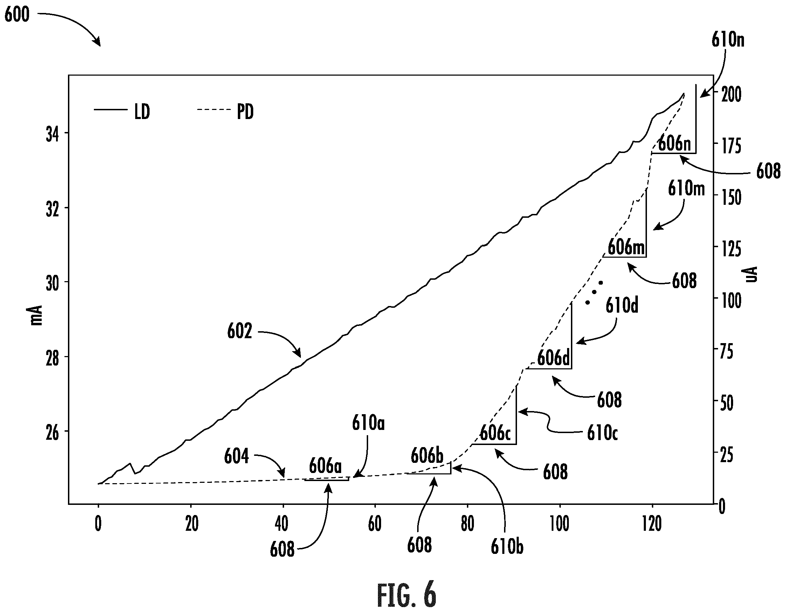

At step 512, the controller may continue to adjust the input current to identify the largest photodiode current difference. In some embodiments, the input current may be adjusted by the digital potentiometer according to a fixed moving window, such that the range of the input current is the same for each difference in photodiode current samples. In an instance in which the range in input currents are all equivalent, the largest photodiode current difference represents the steepest slope and indicates the linear region of operation. The controller may identify a plurality of input current pairs set by the potentiometer and calculate the ratio of the change in the output photodiode current to the fixed input current range established by the digital potentiometer. The controller may use the input current pairs to estimate the slope of the line relating the input current to the photodiode current. FIG. 6 depicts an example graph 600 illustrating an example of a plurality of input current pairs and the corresponding change in photodiode current. As shown in FIG. 6, the width of the difference in input current may be a fixed range (e.g., fixed step size 608) as determined by the digital potentiometer. Once the controller determines a pair with the greatest change in photodiode current (e.g., slope), the controller may identify the region as the linear region of operation. The controller may further determine an approximate slope of the linear region by determining the ratio of the photodiode current difference to the difference in the input current (e.g., fixed step size of the digital potentiometer). For example, in an instance in which the first potentiometer value is 90 and the second potentiometer value is 110, and, the first photodiode current is 27 milliamps and the second photodiode current is 29 milliamps, the slope may be calculated as:

$$slope = \frac{\Delta photodiode\ current}{\Delta potentiometer\ value} = \frac{2nd\ photodiode\ current - 1st\ photodiode\ current}{2nd\ potentiometer\ value - 1st\ potentiometer\ value}$$

$$slope = \frac{29 - 27}{110 - 90} = \frac{2}{20} = 0.1$$

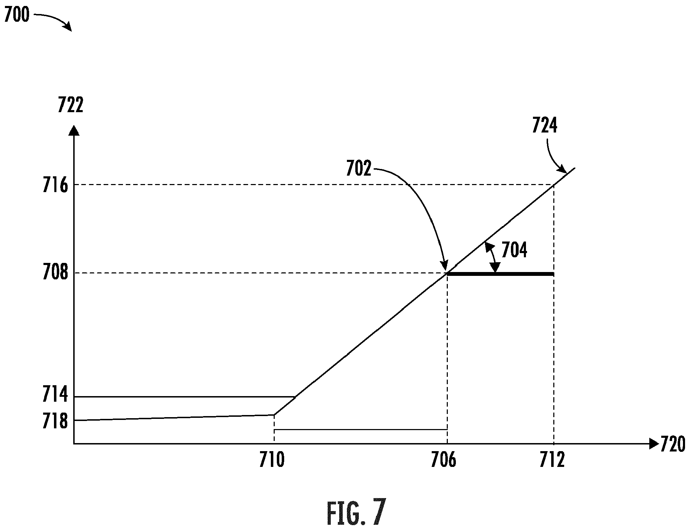

At step 514, the controller may estimate the input current threshold, corresponding to the point at which the photodiode current starts to change linearly with the change in input current (as a function of the potentiometer value), based on the determined slope. In some embodiments, the controller may estimate the input current threshold by determining an equation for the linear region of the photodiode current. The equation for the linear region may be determined based on the slope determined at step 512 and a point on the linear region, for example, the point containing the first photodiode current and the corresponding first input current. The input current threshold represents the minimum input current necessary for the laser diode to produce coherent light. Determination of the minimum threshold output photodiode current above which the laser operates in a coherent region is further described in relation to FIG. 7

At step 516, the operating photodiode output is determined based on the reference potentiometer value corresponding to the input current threshold and the starting point for operating the laser is recorded. The operating photodiode output, in some embodiments, is the target photodiode output during operation that is determined to generate clear and stable hologram images while minimizing power consumption. In some embodiments, a reference photodiode output associated with the input current threshold (set by the digital potentiometer) may be scaled by a pre-determined operating scale factor to determine the target operating photodiode output value. The pre-determined operating scale factor may be any numeric value used to determine the operating photodiode output value in relation to the reference photodiode output. In some embodiments, the pre-determined operating scale factor may be between 1.3 and 1.7; more preferably between 1.35 and 1.65; most preferably between 1.4 and 1.6. In some embodiments, the operating photodiode output value may be determined by multiplying the pre-determined operating scale factor by the input current threshold. For example:

$$operating\_photodiode\_output$$
$$= pre\_determined\_operating\_scale\_factor$$
$$\times reference\ potentiometer\ value$$

The operating photodiode output and associated reference potentiometer value may be used as the starting point for the operation of the laser diode.

In addition, based on the equation for the linear region, a unit step size may be determined. A unit step size may be any numeric value, sequence of numeric values, or range of numeric values in which the photodiode current is maintained during operation of the laser driver circuit. The unit step size may be determined based on the size of the fixed step size in discrete settings of the digital potentiometer. For example, the unit step size may be determined by:

$$unit\ step\ size = \frac{photodiode\ current\ difference}{fixed\ step\ size}$$

where the photodiode current difference corresponds to the difference between the first and second photodiode currents having the largest photodiode current difference as identified at step 512. The photodiode current difference may then be divided by the fixed step size of the digital potentiometer. For example, in an instance in which the first photodiode current is 27 and the second photodiode current is 29, and the fixed step size between discrete settings of the digital potentiometer is 20, the unit step size may be calculated as:

$$unit\ step\ size = \frac{29 - 27}{20} = 0.1$$

At step 518, the calibration parameters are stored. The calibration parameters may include but are not limited to the operating photodiode output, the input current threshold, the reference potentiometer value, and the unit step size. Such calibration parameters may be stored for use by the stabilization algorithm during operation.

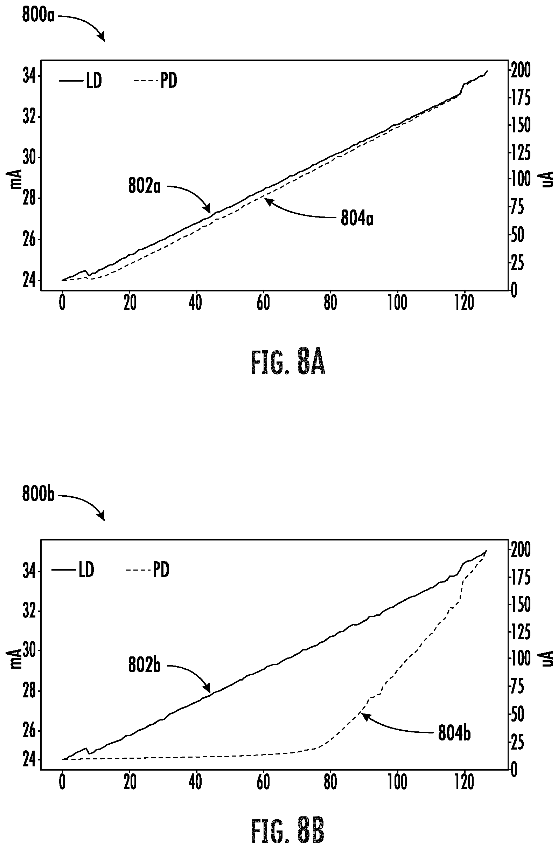

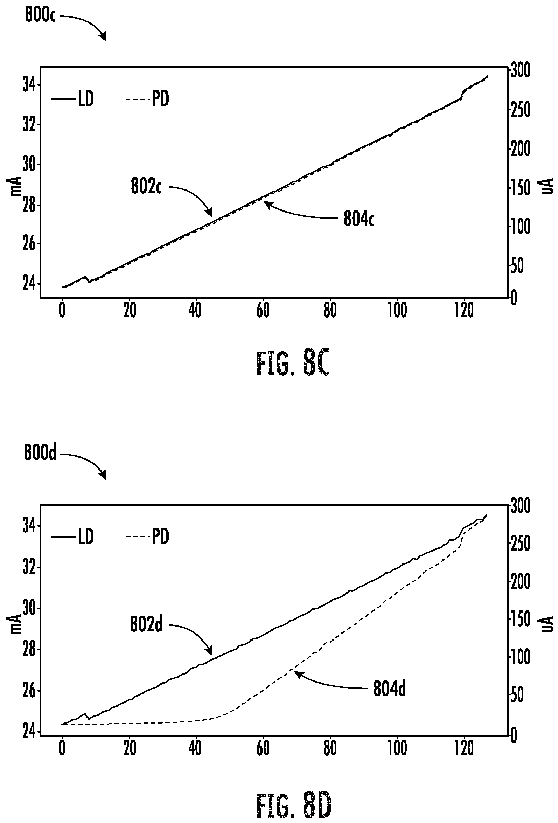

Referring now to FIG. 6, a graph 600 illustrating a method for determining the linear region of operation and associated parameters is provided. FIG. 6 includes example graphs of a laser diode current curve 602 (e.g., input current) and photodiode current curve 604 (e.g., photodiode output value) for a particular example laser driver circuit (e.g., laser driver circuit 100). As further depicted in FIG. 8A - FIG. 8D, a photodiode current curve (e.g., photodiode current curve 604) may be unique for each laser driver circuit, dependent upon the electrical components, including the photodiode and laser diode. FIG. 6 further illustrates a plurality of slopes 606a - 606n that may be determined, each slope comprising a fixed step size 608, corresponding to the fixed step size of the discrete settings of the digital potentiometer, and a photodiode current difference 610a - 610d, corresponding to the difference in photodiode current across the fixed step size at the given input current values.

As depicted in FIG. 6, the laser diode current curve 602 represents the laser diode current (e.g., input current) as a function of the discrete digital potentiometer setting. The discrete digital potentiometer setting may be set by, for example, a wiper register via I2C communication from a connected component. In some embodiments, the discrete digital potentiometer setting may correspond to a resistance value (e.g., ohms). For example, a digital potentiometer may be set between 0 and 10,000 ohms. In some embodiments, the discrete digital potentiometer setting may correspond to a percentage of the max total resistance of the digital potentiometer, for example, 10%, 20%, etc. In some embodiments, the discrete digital potentiometer setting may correspond to an integer value (e.g., 0-127). In some embodiments, the digital potentiometer will receive setting values at a fixed interval (e.g., fixed step size 608). The fixed interval limits the digital potentiometer to be set to values only in accordance with the fixed interval or fixed step size. For example, the fixed step size may be 100 ohms. As shown the fixed step size 608 is the same for each calculated slope 606a - 606n, thus, in some embodiments, to determine the steepest slope, only the photodiode current difference 610a - 610d may be considered.

As depicted in FIG. 6, the photodiode current curve 604 represents the photodiode current (e.g., photodiode output value) as a function of the discrete digital potentiometer setting. As described herein, the discrete digital potentiometer setting may correspond to a fixed step size between the discrete digital potentiometer settings of a digital potentiometer.

In some embodiments, during the calibration algorithm, as depicted in FIG. 4 - FIG. 5, the controller may determine a plurality of slopes (e.g., slope 606a - 606n) at a plurality of different sequential pairs of digital potentiometer settings. For example, as depicted in FIG. 6, the controller may select a first digital potentiometer setting and measure a first photodiode current corresponding to the first digital potentiometer setting. The controller may then select a second digital potentiometer setting, sequential to the first digital potentiometer setting, by incrementing the digital potentiometer at a fixed step size 608. The controller may then measure a second photodiode current corresponding to the second digital potentiometer setting. The controller may then determine the photodiode current difference (e.g., photodiode current difference 610a - 610n) corresponding to the difference between the second photodiode current and the first photodiode current. The controller may determine the photodiode current difference at each of the plurality of different sequential pairs of digital potentiometer settings (e.g., photodiode current difference 610a - 610n). The slope 606a - 606n for each sequential pair of digital potentiometer settings may be calculated by determining the ratio between the photodiode current difference 610a - 610n and the fixed step size 608. For example, the slope 606d may be determined by dividing 610d by 608.

Since the fixed step size 608 is the same for each measurement, the steepest slope corresponds to the sequential pair of digital potentiometer settings having the greatest change in photodiode current, or photodiode current difference 610a - 610n. The sequential pair of digital potentiometer settings having the greatest photodiode current difference 610a - 610n may be used to establish the calibration parameters. For example, the operating photodiode output value may be determined based on the slope of the photodiode current curve 604 at the sequential pair of digital potentiometer settings having the greatest photodiode current difference 610a - 610n.

Utilizing the determined steepest slope, calibration parameters such as the reference potentiometer value, input current threshold, operating photodiode output value, and unit step size may be determined. Determination of the calibration parameters based on the determined slope of the linear region are further described in relation to FIG. 7.

Referring now to FIG. 7, a graph 700 illustrating the determination of calibration parameters based on the determined slope from the linear interpolation of the linear region of the photodiode current curve is provided. As shown in FIG. 7, the x-axis 720 of the graph 700 represents digital potentiometer settings and the y-axis 720 represents the photodiode current (e.g., photodiode output value) corresponding to the digital potentiometer setting.

As described in FIG. 6, the linear region of the photodiode current curve may be estimated based on the steepest slope of a sequential pair of digital potentiometer settings. As depicted in FIG. 7, the line 718 represents the photodiode current when the laser diode is operating in the non-coherent region of illumination, while the line labeled 722 represents the linear interpolation of the linear region of the photodiode current curve as determined in the process described in FIG. 6. For example, the slope 704 corresponds to a sequential pair of digital potentiometer settings (e.g., first digital potentiometer setting 706 and second digital potentiometer setting 712) with the distance between the sequential pairs of digital potentiometer settings representing the fixed step size of the digital potentiometer. Each digital potential potentiometer setting may correspond to a photodiode current. For example, the first digital potentiometer setting 706 at operating point 702 corresponds with the first photodiode current 708 and the second digital potentiometer setting 712 corresponds with the second photodiode current 716. The slope 704 of the linear interpolation 722 may be determined by finding the ratio between the difference between the second photodiode current 716 and the first photodiode current 708 and the fixed step size (e.g., the difference between second digital potentiometer setting 712 and the first digital potentiometer setting 706).

The slope 704 may be used to estimate the digital potentiometer setting corresponding with the input current threshold 710. For example, in some embodiments, the slope 704 of the linear interpolation and one or more points on the photodiode current curve may be used to determine the digital potentiometer value at which the photodiode current is zero. In some embodiments, the point at which the linear interpolation intersects the x-axis 720 may be utilized as an approximation of the digital potentiometer setting corresponding with the input current threshold 710. In some embodiments, the slope 704 of the linear interpolation and one or more points on the photodiode current curve may be used to determine the digital potentiometer value at which the photodiode current drops below a certain minimum photodiode current threshold 718, approximating the photodiode current output when the laser diode is operating in a non-coherent manner. In such an instance, the point at which the linear interpolation intersects the target photodiode current value 718 may be utilized as an approximation of the reference potentiometer value 710 corresponding with the digital potentiometer setting of the input current threshold.

The reference potentiometer value 710 corresponding with the digital potentiometer setting corresponding to the input current threshold may further be utilized to determine the operating photodiode output value 714. During operation, the laser diode produces coherent light at any point above the photodiode output current threshold corresponding to the reference potentiometer value. However, to reduce power consumption, and avoid saturating the target object, the controller may determine a target operating photodiode output value 714. The operating photodiode output value 714 provides a target photodiode current during the execution of the stabilization algorithm as described further in FIG. 9 - FIG. 10. In some embodiments, the operating photodiode output value may be determined by scaling the minimum photodiode current threshold 718 current threshold and/or the associated digital potentiometer value associated with the minimum photodiode current threshold 718 by a pre-determined operating point scale factor. For example, in an instance in which it is determined that the minimum photodiode current threshold 718 is 25 milliamps and the pre-determined operating point scale factor is 1.5, the operating photodiode output value is the photodiode output value associated with the digital potentiometer setting at:

$$operating\ pd\ current = scale\ factor * \text{minimum photodiode current threshold}$$

$$operating\ pd\ current = 1.5 * 25mA = 37.5mA$$

In some embodiments, the pre-determined operating scale factor may be between 1.3 and 1.7; more preferably between 1.35 and 1.65; most preferably between 1.4 and 1.6.

Referring now to FIG. 8A - FIG. 8D, a plurality of graphs 800a - 800d depicting various photodiode current curves 804a - 804d in relation to a range of digital potentiometer input values is provided. As depicted in FIG. 8A - FIG. 8D, each of the graphs 800a - 800d may be associated with a different laser driver circuit. The graphs 800a - 800d depict the variations in photodiode current of different laser driver circuits based on the variation of electrical components comprising the laser driver circuit.

As depicted in FIG. 8A - FIG. 8D, the laser diode current curve 802a - 802d is consistent based on the digital potentiometer settings across the various laser driver circuits. However, the photodiode current curves 804a - 804d vary substantially across the various laser driver circuits. For example, the laser driver circuits of graph 800a and graph 800b exhibit a photodiode current curve 804a, 804c that is nearly linear having a low input current threshold. However, laser driver circuits of graph 800b and graph 800d exhibit a photodiode current curve 804b, 804d with a higher input current threshold and thus a much steeper linear portion starting at much higher input currents.

Referring now to FIG. 9, an example process 900 for controlling the intensity of an illumination source (e.g., laser diode 102) is provided. At step 902, a controller (e.g., controller 106) receives a measured photodiode output value. In some embodiments, a measured photodiode output value may correspond to the output current of a monitoring photodiode (e.g., photodiode 104) during operation of a laser diode 102.

At step 904, a controller compares the measured photodiode output value to the operating photodiode output value. As described in relation to FIG. 4 - FIG. 8D, the controller may determine and save an operating photodiode output value during calibration and calibration updates. The operating photodiode output value may represent a target photodiode current during operation. The controller may compare the measured photodiode output value with the operating photodiode output value.

At step 906, the controller determines a difference between the measured photodiode output value and the operating point photodiode output value.

At step 908, in an instance in which the difference is greater than a unit step size, the controller adjusts the input current via the digital potentiometer. As described in relation to FIG. 4 - FIG. 8D, the controller may determine and save a unit step size representing the maximum deviation of the measured photodiode output value from the operating photodiode output value. The measured photodiode output value represents the intensity of the illumination source. The deviation of the measured photodiode output value from the operating photodiode output value represents a change in the intensity of the illumination source as received by the photodiode. A deviation in the intensity of the illumination source may result in inaccurate and/or inconsistent digital holograms of the target object. As such, the input current may be adjusted by the controller, for example, by altering the configuration of a digital potentiometer.

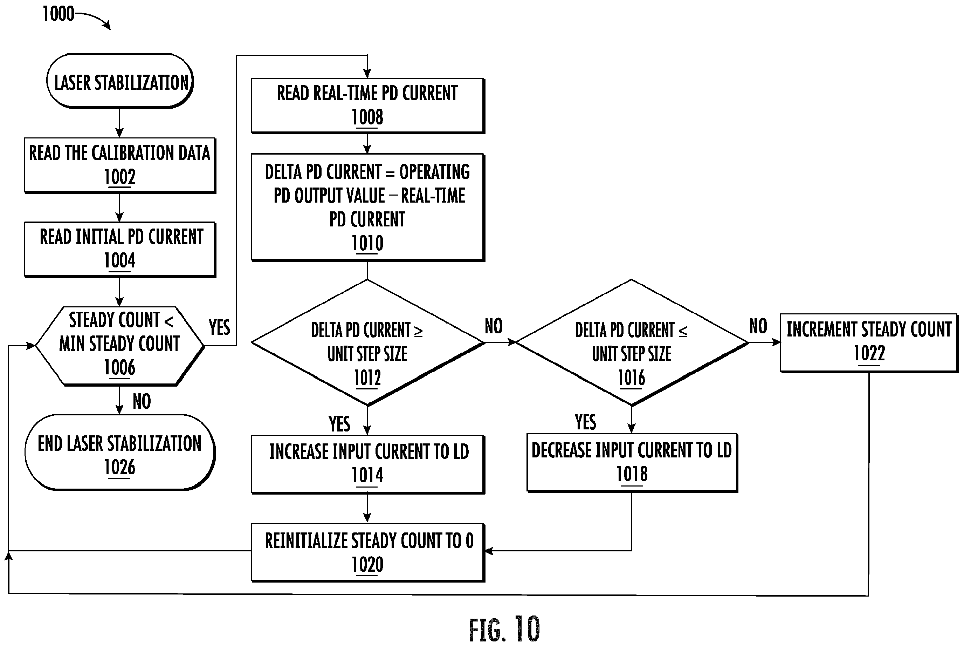

Referring now to FIG. 10, an example laser stabilization algorithm 1000 is provided. The laser stabilization algorithm begins at step 1002. At step 1004, the controller (e.g., controller 106) reads the calibration data stored by the calibration data. The calibration data may include the reference potentiometer value that corresponds to the input current threshold, the operating photodiode output value, the slope of the linear region of the photodiode current curve, the unit step size, and other similar parameters.

At step 1006, the steady count parameter is compared to a minimum steady count. A steady count parameter is utilized to measure the stability of the photodiode current readings. The minimum steady count may be a pre-determined value at which the controller may determine the photodiode current readings are stable. In some embodiments, the minimum steady count may represent a time interval, for example 1 second. In some embodiments, the minimum steady count may represent a count, for example, 30 cycles of the laser stabilization algorithm 1000. In an instance in which the steady count is less than the minimum steady count, meaning the stability of the photodiode current reading has not been established, the laser stabilization algorithm 1000 continues at step 1008. In an instance in which the steady count is greater than or equal to the minimum steady count, the stability of the photodiode current is established and the laser stabilization algorithm 1000 terminates at step 1026.

At step 1008, the controller reads the real-time photodiode current (e.g., real-time photodiode output value). The real-time photodiode current represents the current intensity of light received at the monitoring photodiode at the present time.

At step 1010, a delta photodiode current is determined. The delta photodiode current is equal to the difference between the real-time photodiode current and the operating photodiode output value as determined and stored by the calibration algorithm further described in relation to FIG. 3 - FIG. 8D.

At step 1012, the delta photodiode current is compared to the unit step size. The unit step size may be determined and stored by the calibration algorithm as further described in relation to FIG. 3 - FIG. 8D. The unit step size establishes a threshold deviation of the real-time photodiode current from the operating photodiode current. In general, if the deviation of the real-time photodiode current exceeds the unit step size, the input current to the laser diode may be adjusted. In an instance in which the delta photodiode current is not greater than or equal to the unit step size, the laser stabilization algorithm 1000 continues at step 1014. In an instance in which the delta photodiode current does exceed the unit step size, the intensity of the laser diode is too low and the laser stabilization algorithm 1000 continues at step 1014.

At step 1014, the input current to the laser diode is increased. In some instances, the intensity of the laser diode has diminished, or the input current has been adjusted too low. For example, as the laser driver circuit operates the temperature of the laser diode may increase. Such an increase in temperature may cause the intensity of the light generated by the laser diode to decrease. To continue to provide accurate digital holograms, the input current and subsequent intensity of the light produced by the laser diode must be increased. To continue to provide accurate digital holograms, the input current and subsequent intensity of the light produced by the laser diode must be increased. In some embodiments, the controller may increase the input current to the laser diode by adjusting the parameters of the digital potentiometer. The laser stabilization algorithm 1000 continues at step 1020.

At step 1016, the delta photodiode current is compared to the negative unit step size. In general, if the deviation of the real-time photodiode current exceeds the unit step size, the input current to the laser diode may be adjusted. In an instance in which the delta photodiode current is less than the negative of the unit step size, the laser stabilization algorithm 1000 continues at step 1018. In an instance in which the delta photodiode current is below the negative unit step size, the intensity of the laser diode is too high and the laser stabilization algorithm 1000 then continues at step 1018.

At step 1018, the input current to the laser diode is decreased. In some instances, the intensity of the laser diode may become too intense, or the input current may have been adjusted too high. In such embodiments, the controller may decrease the input current to the laser diode by adjusting the parameters of the digital potentiometer. The laser stabilization algorithm 1000 then continues at step 1020.

At step 1020, the steady count is reinitialized to zero. The laser stabilization algorithm 1000 continues at step 1006 where the stability of the laser output is re-tested with the adjusted input current to the laser diode.

At step 1022, the steady count is incremented. The determination that the deviation of the real-time photodiode current does not exceed the unit step size may indicate the input current to the laser diode is accurate resulting in accurate digital holograms of the target object. The laser stabilization algorithm 1000 may increment the steady count to ensure the stability of the real-time photodiode current. In some embodiments, the laser stabilization algorithm 1000 may pause, or wait between iterations of the laser stabilization algorithm 1000 to measure the real-time photodiode current over an extended period of time. The laser stabilization algorithm 1000 continues at step 1006.

Many modifications and other embodiments of the inventions set forth herein will come to mind to one skilled in the art to which these inventions pertain having the benefit of teachings presented in the foregoing descriptions and the associated drawings. Although the figures only show certain components of the apparatus and systems described herein, it is understood that various other components may be used in conjunction with the system. Therefore, it is to be understood that the inventions are not to be limited to the specific embodiments disclosed and that modifications and other embodiments are intended to be included within the scope of the appended claims. Moreover, the steps in the method described above may not necessarily occur in the order depicted in the accompanying diagrams, and in some cases one or more of the steps depicted may occur substantially simultaneously, or additional steps may be involved. Although specific terms are employed herein, they are used in a generic and descriptive sense only and not for purposes of limitation.

While various embodiments in accordance with the principles disclosed herein have been shown and described above, modifications thereof may be made by one skilled in the art without departing from the spirit and the teachings of the disclosure. The embodiments described herein are representative only and are not intended to be limiting. Many variations, combinations, and modifications are possible and are within the scope of the disclosure. The disclosed embodiments relate primarily to a laser driver circuit on a blood cytometry device, however, one skilled in the art may recognize that such principles may be applied to any application requiring a highly accurate laser diode, for example, any laser utilized in digital holographic microscopy applications. Alternative embodiments that result from combining, integrating, and/or omitting features of the embodiment(s) are also within the scope of the disclosure. Accordingly, the scope of protection is not limited by the description set out above.

Additionally, the section headings used herein are provided for consistency with the suggestions under 37 C.F.R. 1.77 or to otherwise provide organizational cues. These headings shall not limit or characterize the invention(s) set out in any claims that may issue from this disclosure.

Use of broader terms such as "comprises," "includes," and "having" should be understood to provide support for narrower terms such as "consisting of," "consisting essentially of," and "comprised substantially of' Use of the terms "optionally," "may," "might," "possibly," and the like with respect to any element of an embodiment means that the element is not required, or alternatively, the element is required, both alternatives being within the scope of the embodiment(s). Also, references to examples are merely provided for illustrative purposes, and are not intended to be exclusive.

**Claims**

1.  A method for controlling an intensity of light from an illumination source, the method comprising:

determining a slope representing a relation of a change in a photodiode output value received from a monitoring photodiode to a change in an input current transmitted to the illumination source,
wherein the photodiode output value corresponds to an intensity of the light received at the monitoring photodiode; and
selecting an operating photodiode output value based at least in part on the slope.

2. The method of Claim 1, further comprising adjusting the input current transmitted to the illumination source to maintain a real-time photodiode output value at or near the operating photodiode output value.

3. The method of Claim 2, wherein adjusting the input current provided to the illumination source further comprises:

receiving a measured photodiode output value;
comparing the measured photodiode output value to the operating photodiode output value;
determining a difference between the measured photodiode output value and the operating point photodiode output value; and
in an instance in which the difference is greater than a unit step size, adjusting the input current.

4. The method of Claim 1, where determining the slope comprises:

determining an input current difference representing a difference between a first input current and a second input current;
determining a photodiode output difference representing a difference between a first photodiode output value and a second photodiode output value,
wherein the first photodiode output value corresponds to the first input current and the second photodiode output value corresponds to the second input current; and
determining a ratio between the input current difference and the photodiode output difference.

5. The method of Claim 4, wherein selecting the operating photodiode output value further comprises:

determining a plurality of slopes, each slope corresponding to a different range of input currents and corresponding range of photodiode output values; and
selecting the operating photodiode output value within the range of photodiode output values corresponding to the range of input currents and corresponding range of photodiode output values having a steepest slope.

6. The method of Claim 1, wherein the illumination source is a laser diode having an input current threshold corresponding to a minimum input current at which the laser diode will produce coherent light, and wherein the method further comprises:

determining a linear approximation of a portion of a photodiode output current curve based at least in part on the slope and the operating photodiode output value,
wherein the photodiode output current curve represents the relation of the input current to the photodiode output value; and
determining the input current threshold based on an intersection point at which the photodiode output value of the linear approximation is zero,
wherein the operating photodiode output value is selected by scaling the input current threshold by a predetermined operating point scale factor.

7. The method of Claim 6, wherein the operating point scale factor is between 1.4 and 1.6.

8. The method of Claim 1, wherein the input current is controlled by a potentiometer.

9. A system comprising:

an illumination source;
a monitoring photodiode positioned to receive light from the illumination source; and
a controller comprising a processor and an instruction memory including program code, the instruction memory and program code configured to, with the processor, cause the message handler processor to:

determine a slope representing a relation of a change in a photodiode output value received from the monitoring photodiode to a change in an input current transmitted to the illumination source;

wherein the photodiode output value corresponds to the intensity of light received at the monitoring photodiode; and

select an operating photodiode output value based at least in part on the slope.

10. The system of Claim 9, wherein the controller is further configured to adjust the input current transmitted to the illumination source to maintain a real-time photodiode output value at or near the operating photodiode output value.

11. The system of Claim 9, wherein determining the slope comprises:

determining an input current difference representing a first difference between a first input current and a second input current;

determining a photodiode output difference representing a second difference between a first photodiode output value and a second photodiode output value,

wherein the first photodiode output value corresponds to the first input current and the second photodiode output value corresponds to the second input current; and

determining a ratio between the input current difference and the photodiode output difference.

12. The system of Claim 11, wherein determining the operating photodiode output value further comprises:

determining a plurality of slopes, each slope corresponding to a different range of input currents and corresponding range of photodiode output values; and

selecting the operating photodiode output value within the range of photodiode output values corresponding to the range of input currents and corresponding range of photodiode output values having a steepest slope.

13. The system of Claim 9, wherein the illumination source is a laser diode having an input current threshold corresponding to a minimum input current at which the laser diode will produce coherent light, and wherein the controller is further configured to:

determine a linear approximation of a portion of a photodiode output current curve based at least in part on the slope and the operating photodiode output value,

wherein the photodiode output current curve represents the relation of the input current to the photodiode output value; and

determine the input current threshold based on an intersection point at which the photodiode output value of the linear approximation is zero,

wherein the operating photodiode output value is selected by scaling the input current threshold by a pre-determined operating point scale factor.

14. The system of Claim 9, further comprising a potentiometer communicatively connected to the controller and electrically connected to the illumination source, wherein the controller controls the input current to the illumination source by transmitting an electrical signal to the potentiometer.

15. A computer program product for controlling an intensity of an illumination source, the computer program product comprising at least one non-transitory computer-readable storage medium having computer-readable program code portions stored therein, the computer-readable program code portions comprising an executable portion configured to:

determine a slope representing a relation of a change in a photodiode output value received from a monitoring photodiode to a change in an input current transmitted to the illumination source,

wherein the photodiode output value corresponds to the intensity of a light received at the monitoring photodiode; and

select an operating photodiode output value based at least in part on the slope.

FIG. 1

106

LASER DIODE WITH
MONITORING PHOTODIODE
INTERFACE CIRCUITRY
212

DIGITAL POTENTIOMETER
INTERFACE CIRCUITRY
210

DATA STORAGE
MEDIA
206

PROCESSOR
202

INPUT/OUTPUT
CIRCUITRY
204

COMMUNICATIONS
CIRCUITRY
208

FIG. 2

FIG. 3

Flowchart 300:

LASER DRIVER CIRCUIT POWER ON 302 → LASER HARDWARE INITIALIZATION 304 → CALIBRATION ALGORITHM INITIALIZATION 306 → CALIBRATION PARAMETERS CALCULATED 308 → STORE CALIBRATION PARAMETERS 310 → READ CALIBRATION PARAMETERS 312 → STABILIZATION ALGORITHM EXECUTES 314 → LASER HARDWARE UPDATE 316 → CAPTURE IMAGE, DETERMINE AUTO EXPOSURE VALUE 318 → AUTO EXPOSURE > THRESHOLD? 320

NO → UPDATE CALIBRATION PARAMETER 322 → STABILIZATION ALGORITHM EXECUTES 314

YES → GENERATE A HOLOGRAM IMAGE 324

400

402 DETERMINE A SLOPE
REPRESENTING A RELATION OF A
CHANGE IN A PHOTODIODE
OUTPUT VALUE RECEIVED FROM A
MONITORING PHOTODIODE TO A
CHANGE IN AN INPUT CURRENT
TRANSMITTED TO THE
ILLUMINATION SOURCE,
WHEREIN THE PHOTODIODE
OUTPUT VALUE CORRESPONDS TO
THE INTENSITY OF LIGHT
RECEIVED AT THE MONITORING
PHOTODIODE

404 SELECT AN OPERATING
PHOTODIODE OUTPUT VALUE
BASED AT LEAST IN PART ON THE
SLOPE

FIG. 4

500 —➤

**TRIGGER CALIBRATION ALGORITHM**
502

↓

**ADJUST INPUT CURRENT VIA DIGITAL POTENTIOMETER**
504

508 ↓

**MEASURE AND RECORD THE PHOTODIODE CURRENT**
506

↓

**CALCULATE DIFFERENCE BETWEEN PHOTODIODE CURRENT SAMPLES WITH RESPECT TO 2 SEQUENTIAL INPUT CURRENTS CORRESPONDING TO THE POTENTIOMETER FIXED MOVING WINDOW**
510

↓

**ADJUST THE POTENTIOMETER TO VARY THE INPUT CURRENT TO IDENTIFY THE LARGEST DIFFERENCE IN PHOTODIODE CURRENT**
512

**ESTIMATE THE INPUT CURRENT THRESHOLD, CORRESPONDING TO THE POINT AT WHICH THE PHOTODIODE CURRENT STARTS TO CHANGE LINEARLY WITH THE CHANGE IN INPUT CURRENT (AS A FUNCTION OF THE POTENTIOMETER VALUE), BASED ON THE DETERMINED SLOPE**
514

↓

**DETERMINE THE OPERATING PHOTODIODE OUTPUT AND RECORD THE STARTING POINT FOR OPERATING THE LASER**
516

↓

**STORE THE CALIBRATION PARAMETERS**
518

↓

**END CALIBRATION**
520

FIG. 5

FIG. 6

FIG. 7

EP 4 439 883 A1

**FIG. 8A**

**FIG. 8B**

FIG. 8C

FIG. 8D

900

902 — RECEIVE A MEASURED PHOTODIODE OUTPUT VALUE

904 — COMPARE THE MEASURED PHOTODIODE OUTPUT VALUE TO THE OPERATING PHOTODIODE OUTPUT VALUE

906 — DETERMINE A DIFFERENCE BETWEEN THE MEASURED PHOTODIODE OUTPUT VALUE AND THE OPERATING POINT PHOTODIODE OUTPUT VALUE

908 — IN AN INSTANCE IN WHICH THE DIFFERENCE IS GREATER THAN A UNIT STEP SIZE, ADJUST THE INPUT CURRENT VIA POTENTIOMETER

FIG. 9

1000

```
         ┌─────────────────────┐              ┌──────────────────────────┐
         │  LASER STABILIZATION │              │ READ REAL-TIME PD CURRENT│
         └──────────┬──────────┘              │          1008            │
                    │                          └────────────┬─────────────┘
                    ▼                                        │
         ┌─────────────────────┐                            ▼
         │READ THE CALIBRATION  │              ┌──────────────────────────┐
         │     DATA  1002       │              │ DELTA PD CURRENT = OPERATING│
         └──────────┬──────────┘              │ PD OUTPUT VALUE − REAL-TIME│
                    │                          │       PD CURRENT          │
                    ▼                          │          1010            │
         ┌─────────────────────┐              └────────────┬─────────────┘
         │READ INITIAL PD CURRENT│                          │
         │        1004         │                            ▼
         └──────────┬──────────┘
```

READ REAL-TIME PD CURRENT
1008

DELTA PD CURRENT = OPERATING PD OUTPUT VALUE − REAL-TIME PD CURRENT
1010

STEADY COUNT < MIN STEADY COUNT
1006 — YES

DELTA PD CURRENT ≥ UNIT STEP SIZE
1012 — NO → DELTA PD CURRENT ≤ UNIT STEP SIZE
1016 — NO → INCREMENT STEADY COUNT
1022

NO

END LASER STABILIZATION
1026

YES
INCREASE INPUT CURRENT TO LD
1014

YES
DECREASE INPUT CURRENT TO LD
1018

REINITIALIZE STEADY COUNT TO 0
1020

FIG. 10

Europäisches
Patentamt

European
Patent Office

Office européen
des brevets

# EUROPEAN SEARCH REPORT

Application Number

EP 24 15 9479

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 019 769 A (LEVINSON FRANK H [US]) 28 May 1991 (1991-05-28) | 1-5, 8-12,15 | INV. H01S5/068 |
| Y | * abstract; figures 2,3,8,9 * <br> * column 8, lines 15-24 * <br> * column 10, lines 48-60 * <br> * column 11, lines 16-24,59-66 * | 6,7,13, 14 | H01S5/0683 |
| Y | US 4 355 395 A (SALTER STUART R ET AL) 19 October 1982 (1982-10-19) * figure 2 * | 6,7,13, 14 | |
| Y | US 2003/219051 A1 (HSIEH JOHN [US]) 27 November 2003 (2003-11-27) * paragraph [0029] * | 6,7,13, 14 | |
| Y | GEOFF W TAYLOR ET AL: "Optimization of the Operating Point of a Vertical-Cavity Surface-Emitting Laser", IEEE JOURNAL OF QUANTUM ELECTRONICS, IEEE, USA, vol. 32, no. 8, 1 August 1996 (1996-08-01) , XP011051453, ISSN: 0018-9197 * page 1442, left-hand column * | 6,7,13, 14 | |

TECHNICAL FIELDS SEARCHED (IPC)

H01S

The present search report has been drawn up for all claims

| Place of search | Date of completion of the search | Examiner |
|---|---|---|
| Munich | 23 July 2024 | Meacher, David |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

.............................................................................................

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 24 15 9479

This annex lists the patent family members relating to the patent documents cited in the above-mentioned European search report.
The members are as contained in the European Patent Office EDP file on
The European Patent Office is in no way liable for these particulars which are merely given for the purpose of information.

23-07-2024

| Patent document cited in search report | | Publication date | Patent family member(s) | | Publication date |
|---|---|---|---|---|---|
| US 5019769 | A | 28-05-1991 | AU | 654825 B2 | 24-11-1994 |
| | | | DE | 69127700 T2 | 19-03-1998 |
| | | | EP | 0548111 A1 | 30-06-1993 |
| | | | JP | 3248720 B2 | 21-01-2002 |
| | | | JP | H06504405 A | 19-05-1994 |
| | | | US | 5019769 A | 28-05-1991 |
| | | | WO | 9205608 A1 | 02-04-1992 |
| US 4355395 | A | 19-10-1982 | NONE | | |
| US 2003219051 | A1 | 27-11-2003 | AT | E355641 T1 | 15-03-2006 |
| | | | AU | 2003234219 A1 | 12-12-2003 |
| | | | DE | 60312157 T2 | 29-11-2007 |
| | | | EP | 1509977 A1 | 02-03-2005 |
| | | | MY | 141492 A | 30-04-2010 |
| | | | US | 2003219051 A1 | 27-11-2003 |
| | | | WO | 03100927 A1 | 04-12-2003 |

EPO FORM P0459

For more details about this annex : see Official Journal of the European Patent Office, No. 12/82